(19) **Europäisches Patentamt**
**European Patent Office**
**Office européen des brevets**

(11) **EP 1 953 558 A1**

(12) **DEMANDE DE BREVET EUROPEEN**

(43) Date de publication:
**06.08.2008 Bulletin 2008/32**

(51) Int Cl.:
***G01R 31/26*** *(2006.01)*

(21) Numéro de dépôt: **08101163.7**

(22) Date de dépôt: **31.01.2008**

(84) Etats contractants désignés:
**AT BE BG CH CY CZ DE DK EE ES FI FR GB GR
HR HU IE IS IT LI LT LU LV MC MT NL NO PL PT
RO SE SI SK TR**
Etats d'extension désignés:
**AL BA MK RS**

(30) Priorité: **02.02.2007 FR 0753039**

(71) Demandeur: **COMMISSARIAT A L'ENERGIE
ATOMIQUE
75015 Paris (FR)**

(72) Inventeur: **Valentian, Alexandre
Gaulle
38120, SAINT EGREVE (FR)**

(74) Mandataire: **Esselin, Sophie et al
Marks & Clerk France
31-33 Avenue Aristide Briand
94117 Arcueil Cedex (FR)**

(54) **Procédé et circuit pour ameliorer la durée de vie des transistors a effet de champ**

(57)      L'invention concerne un procédé et un circuit pour améliorer la durée de vie des circuits intégrés électroniques à transistors à effet de champ, et notamment ceux à diélectrique de grille mince.

Selon l'invention, une mesure de vieillissement $t_S$ est fournie par la mesure du temps de charge ou décharge à une tension de référence $V_{REF}$ de la grille d'un transistor à effet de champ T1, préalablement préchargée à une tension de test prédéfinie $V_P$, et mise en haute impédance. En fonction de la mesure de vieillissement obtenue, des conditions de polarisation en tension opérationnelles du transistor peuvent être maintenues ou modifiées, pour réduire le stress appliqué au diélectrique

FIG.3

Printed by Jouve, 75001 PARIS (FR)

# Description

L'invention concerne un procédé et un circuit pour améliorer la durée de vie des circuits intégrés électroniques à transistors à effet de champ, et notamment ceux à diélectrique de grille mince.

Dans les applications dans lesquelles l'alimentation est fournie par une batterie ou une pile, par exemple dans les téléphones et ordinateurs portables, dans les appareils photographiques numériques..., et pour toutes les applications en électronique rapide, il est particulièrement intéressant d'utiliser des transistors à faible consommation, à faible encombrement et à fréquences élevées de fonctionnement. Ces différentes qualités sont offertes par les transistors à effet de champ, et tout particulièrement les transistors MOS (Métal/Oxyde/Semiconducteur) et CMOS à transistors MOS complémentaires. En effet, ces technologies ont pu évoluer de génération en génération vers des dimensions géométriques toujours plus réduites, avec une diminution proportionnelle des tensions de seuil et d'alimentation et des vitesses de fonctionnement accrues.

Néanmoins la diminution des dimensions géométriques entraîne une augmentation exponentielle des courants de fuite entre source et drain, encore appelés courants sous le seuil, qui sont donc présents même lorsque le transistor est bloqué : pour les dernières générations sous-microniques, ces courants de fuite deviennent une source non négligeable de pertes d'énergie.

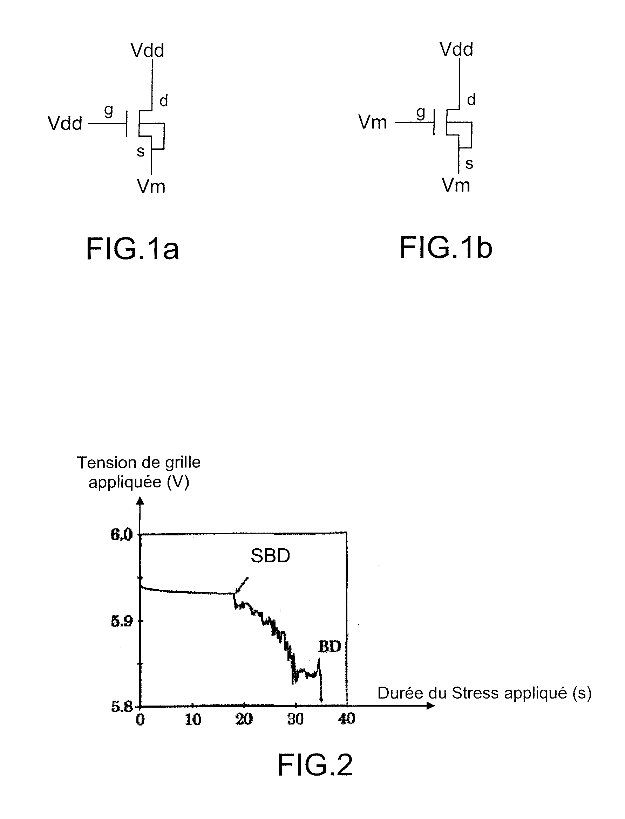

Il est donc devenu nécessaire de diminuer les effets de ces courants de fuite, ce qui a conduit à réduire en moindre proportion les tensions d'alimentation et les tensions de seuil des transistors. Ceci a pour conséquence directe que le champ électrique appliqué aux bornes du diélectrique de grille est plus important. Le diélectrique est donc soumis à plus de stress, notamment à l'endroit où la grille surplombe le drain et/ou la source. Si on prend à titre d'exemple un transistor NMOS, à l'état passant, son drain et sa grille sont polarisés à Vdd et sa source à Vm, si on note Vdd et Vm les deux niveaux de tension d'alimentation logique comme illustré sur la figure 1 a : le diélectrique subit un stress à l'endroit où la grille surplombe la source. A l'état bloqué, sa grille est amenée à Vm, la polarisation du drain et de la source restant inchangée, comme illustré sur la figure 1b : le diélectrique subit un stress à l'endroit où la grille surplombe le drain. Pour un transistor PMOS, on inverse la position des drains d et sources s sur les figures.

Or des prévisions récentes publiées dans le document : James Stathis, "Gate Oxide Reliability for nanoscale CMOS", International Symposium on Physical and Failure Analysis, pp 127-130, Juin 2005, montrent qu'avec la réduction des dimensions des transistors, un diélectrique de grille va supporter un champ électrique à ses bornes de l'ordre de 1 Volt par nanomètre d'épaisseur.

Ainsi, la fiabilité des transistors à diélectrique mince utilisés dans des circuits logiques, notamment en logique rapide, et alimentés sous des conditions de polarisation en tension de leurs grilles, source et drain correspondant aux niveaux de tension d'alimentation logique du circuit, est diminuée.

Le stress subi par le diélectrique de grille est encore augmenté dans les transistors de puissance utilisés dans des étages analogiques de circuits électroniques et commandés par des tensions plus élevées que la tension d'alimentation logique, pour rendre fortement passant ou fortement bloqué ces transistors. Considérons par exemple des transistors de puissance utilisés comme dispositifs de coupure de l'alimentation de tout ou partie d'un circuit électronique en mode de veille, afin de réduire les courants de fuite en mode de veille. Les transistors dits SCCMOS *("Super Cut-off CMOS")* sont un exemple de transistors utilisés à de telles fonctions. On en trouve notamment une description dans le document publié suivant : H. Kawaguchi et al., "A super Cut-Off CMOS (SCCMOS), Scheme for 0,5 V Supply Voltage with Picoampere Stand-by Current", IEEE Journal of Solid State Circuits, vol. 35 N°10, pp 1498-1501, Oct 2000. Ils sont caractérisés par leur capacité à conduire un fort courant en mode passant, un faible courant de fuite à l'état bloqué pour une surface occupée sur le circuit optimale (au regard du courant à l'état passant).

Pour une telle utilisation, en mode veille, le transistor est bloqué avec la grille du transistor "sur-polarisée" en inverse, ce qui permet d'obtenir un courant de fuite sous le seuil minimal. En effet, le courant de fuite sous le seuil diminue exponentiellement lorsque l'on polarise la grille plus négativement pour un NMOS, ou plus positivement pour un PMOS. On entend par sur-polarisation inverse, une polarisation de la grille à une tension plus basse que la borne la plus négative de la tension d'alimentation logique du circuit, pour un transistor NMOS, ou plus haute que la borne d'alimentation la plus positive de la tension d'alimentation logique pour un circuit PMOS.

Ce mode de polarisation inverse conduit à un stress accru du diélectrique de grille, dans l'exemple, plus spécialement à l'endroit où la grille surplombe le drain, la tension grille drain devenant supérieure à la tension d'alimentation logique. La conséquence en est une baisse de la fiabilité du transistor de puissance.

Ainsi, d'une manière générale la "miniaturisation" des transistors à effet de champ conduit à une réduction de leur fiabilité et par suite de la durée de vie des circuits intégrés électroniques utilisant de tels transistors. L'enjeu est donc important notamment en logique rapide et dans toutes les applications du type "portable".

Un objectif de l'invention est ainsi d'augmenter la fiabilité des transistors à effet de champ.

Or on a pu observer que dans les diélectriques minces, le stress ne conduit pas à une rupture brutale du diélectrique comme il se produit dans les diélectriques épais, mais au contraire à un phénomène de rupture douce. Ce phénomène de rupture douce est notamment expliqué dans le document publié suivant : Depas et al.

"Soft Breakdown of Ultra-thin Gate Oxide Layers", IEEE Transactions on Electron devices Vol.43, no. 3, Sept. 1996. Il est illustré sur la figure 2, en prenant en exemple un transistor en technologie MOS sur substrat silicium, avec comme diélectrique de grille, de l'oxyde de silicium. En ordonnée est indiquée la tension de grille qui est appliquée pour maintenir un courant constant à travers le diélectrique. Dans un premier temps, la tension appliquée diminue lentement : cette partie de la courbe jusqu'au point SBD correspond à la création de défauts (pièges à porteurs) dans le diélectrique SiO2 et à l'interface substrat/diélectrique Si/Si02, due à l'injection tunnel d'électrons sous un fort champ électrique. Lorsque ces défauts atteignent localement une densité suffisante, un chemin de conduction est créé : c'est la première rupture (point SBD sur la figure). Cette première rupture peut être suivie d'autres ruptures. Lorsque le ou les chemins de conduction se sont élargis par effet thermique, et se sont rejoints, le taux d'évolution du courant à travers le diélectrique devient très élevé jusqu'à la mise hors-circuit du transistor (point BD).

Le phénomène de rupture douce observé rend possible une détection ou un suivi du vieillissement du diélectrique, avant d'arriver au point de rupture final BD.

L'idée à la base de l'invention est ainsi en quelque sorte de détecter le point SBD de la courbe, pour adapter alors les conditions de polarisation du transistor dans le but de réduire légèrement le stress appliqué au diélectrique. En effet la durée de vie d'un diélectrique varie de façon exponentielle avec le stress appliqué : comme expliqué dans le document publié de M. A. Khalil, et Al, "Extreme-Voltage Stress Vector Generation of Analog CMOS ICs for Gate-Oxide Reliability Enhancement," Int. Test Conference, pp. 348-357, 2001, la durée de vie $t_{BD}$ d'un transistor à effet de champ pour une technologie donnée est donnée par l'équation suivante :

$$t_{bd} = \tau_0 \cdot e^{\frac{G \cdot T_{eff}}{V_{ox}}},$$

où $t_{BD}$ ("*time to breakdown*") est la durée de vie intrinsèque du diélectrique soumis à la tension $V_{ox}$; $T_{eff}$ est l'épaisseur effective du diélectrique; $V_{ox}$ est la tension effective aux bornes du diélectrique; G est la pente de la courbe du logarithme de la durée $t_{BD}$ en fonction de $1/E_{ox}$, où $E_{ox}$ est le champ électrique dans le diélectrique.

Dans un exemple d'une technologie CMOS 65 nm (nanomètres), on a $\tau_0$=10ps (picosecondes), G=40 giga-Volts par mètre. Ainsi, une diminution de la tension $V_{ox}$ de seulement 100mV permet d'augmenter le temps avant rupture $t_{BD}$ de plus d'un ordre de grandeur (x10). Une faible réduction de la tension, qui va donc dégrader les performances du transistor de façon très limitée, va par contre permettre d'augmenter considérablement la durée de vie du transistor.

L'idée à la base de l'invention est ainsi de permettre une mesure du vieillissement du diélectrique de grille, pour adapter le cas échéant les conditions de polarisation appliquées au transistor pour diminuer le stress appliqué au diélectrique à mesure qu'il vieillit. Il s'agit de faire un compromis entre une dégradation des performances du transistor, typiquement la vitesse de commutation, au profit d'une augmentation de sa durée de vie d'un voire plusieurs ordres de grandeur.

Mesurer le vieillissement du diélectrique, c'est évaluer le courant de fuite dans le diélectrique. Or la grille d'un transistor à effet de champ constitue une électrode d'une capacité formée avec le diélectrique (Capacité MOS) que l'on appelle capacité de grille dans la suite. On peut ainsi utiliser cette capacité intrinsèque pour évaluer le courant de fuite, en mesurant un temps de charge ou décharge de la capacité par ce courant. Ceci est particulièrement avantageux pour la simplicité de la mise en oeuvre, ainsi que pour la robustesse de la mesure obtenue, au regard des variations d'épaisseur du diélectrique de grille due aux dispersions technologiques. En effet, comme on peut notamment le lire dans le document publié : Z. Han et al, "Gate leakage current simulation by Boltzman Transport Equation and its dependence on the gate oxide thickness", International conference on Semiconductor Processes and devices SISPAD, pp. 247-250, Sept.1999, la valeur de la capacité de grille varie linéairement avec l'épaisseur du diélectrique, tandis que le courant de fuite du diélectrique varie lui exponentiellement avec cette épaisseur. Malgré deux évolutions antagonistes, le temps de charge ou de décharge de la capacité de grille va bien augmenter exponentiellement avec l'épaisseur du diélectrique, correspondant à une diminution du stress subit par le diélectrique.

La mesure du vieillissement permet, par comparaison à une valeur de référence, de fournir une information de vieillissement du diélectrique.

Avantageusement, elle permet d'adapter les conditions de polarisation de tension du ou des transistors d'un circuit à ce vieillissement, de façon à réduire le stress subit par le diélectrique. La tension de polarisation que l'on choisit de modifier peut varier selon le cas. Notamment, pour des transistors utilisés dans une porte ou un étage logique, on peut choisir de mettre en oeuvre une diminution progressive de la tension d'alimentation logique du circuit intégré, en fonction du vieillissement mesuré. Pour un transistor de puissance, on peut choisir de mettre en oeuvre une diminution progressive de la valeur maximale (négative ou positive) de la tension de commande de grille, en fonction de la mesure de vieillissement.

L'invention concerne donc un procédé de test pour augmenter la durée de vie d'un transistor à effet de champ dans un circuit électronique, caractérisé en ce qu'il comprend :

- une phase de précharge de la grille dudit transistor à une tension de test prédéfinie, puis la mise en haute impédance de la grille du transistor,

- une phase de mesure de vieillissement à l'aide d'un temps de charge ou de décharge de la grille dudit transistor pour passer dudit niveau de tension de test prédéfinie à une tension de référence,
- une étape de détermination, pour décider le maintien ou la modification d'au moins une tension de polarisation opérationnelle dudit transistor, en fonction de ladite mesure de vieillissement.

L'invention concerne aussi un circuit électronique comprenant au moins un transistor à effet de champ, caractérisé en ce qu'il comprend un circuit de mesure de vieillissement dudit transistor activé au moins à chaque mise sous tension du circuit électronique, ledit circuit de mesure comprenant

- des moyens pour précharger la grille dudit transistor à une tension de test prédéfinie, puis la mettre en haute impédance, des moyens pour fournir une mesure de vieillissement correspondant à un temps de charge ou décharge de la grille à une tension de référence et des moyens de détermination d'au moins une tension de polarisation opérationnelle du transistor, en fonction de ladite mesure de vieillissement.

L'invention s'applique aux transistors de puissance mais aussi aux transistors d'un circuit logique, pour améliorer la durée de vie des circuits électroniques en réduisant le stress appliqué aux diélectriques des transistors dès qu'un vieillissement peut être constaté.

D'autres caractéristiques et avantages de l'invention apparaîtront à la lecture de la description détaillée qui suit et qui est faite en référence aux dessins annexés dans lesquels :

- les figures 1a et 1b sont les schémas symboliques d'un transistor NMOS à l'état passant et à l'état bloqué ;
- la figure 2 représente le phénomène de rupture douce dans un diélectrique mince d'un transistor à effet de champ ;
- la figure 3 est un schéma bloc d'un dispositif de mesure de vieillissement d'un transistor à effet de champ d'un circuit logique;
- la figure 4 est un organigramme correspondant d'un procédé selon l'invention ;
- la figure 5 illustre un exemple de réalisation d'un circuit de mesure du temps de charge ou décharge du noeud de grille du transistor ;
- la figure 6 illustre un exemple de réalisation d'un circuit d'élaboration d'une consigne avec asservissement en vue de la réduction du stress appliqué au diélectrique de grille d'un transistor;
- la figure 7 est un schéma simplifié d'un circuit logique comprenant des transistors témoins de vieillissement dispersés; et un dispositif associé pour surveiller le vieillissement du circuit logique et réduire le stress le cas échéant par adaptation des niveaux de tension d'alimentation logique.

Notations utilisées : Vm et Vdd désignent les deux niveaux de tension d'alimentation logique du circuit. Typiquement Vdd est une tension positive et Vm une tension nulle (0 volt) qui correspondent par convention aux niveaux logiques 1 et 0 respectivement. On note $V_{GN}$, la tension de polarisation de grille correspondant à un état bloqué d'un transistor PMOS. Cette tension $V_{GN}$ est typiquement égale à Vdd, dans le cas d'un transistor PMOS d'une porte logique. Ce peut être une tension supérieure à Vdd dans le cas d'un transistor de puissance, que l'on veut très fortement bloquer.

Dans les figures, les signaux ou éléments identiques sont identifiés par la même référence.

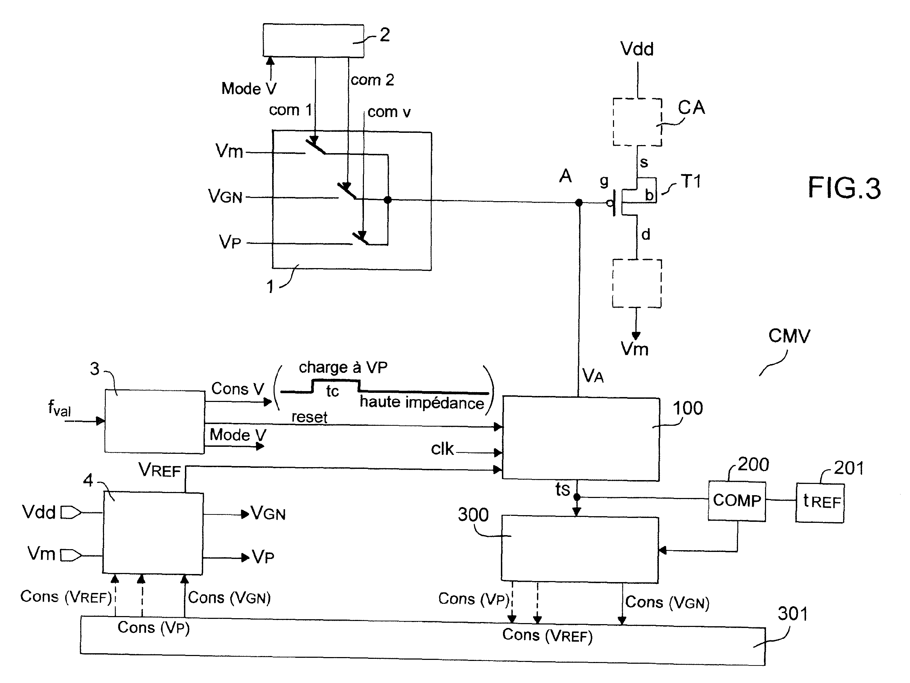

La figure 3 illustre un dispositif de mesure de vieillissement du diélectrique d'un transistor à effet de champ T1 d'un circuit électrique. Dans l'exemple, c'est un transistor PMOS. Son drain d et sa source s sont connectés, directement ou indirectement, à Vm et Vdd respectivement. La prise b de substrat ou de caisson est attachée à la source.

Un circuit 1 de commande du transistor permet d'appliquer une tension donnée sur la grille g du transistor, en fonction de signaux de commande qu'il reçoit, ou de laisser la grille en haute impédance, c'est à dire non connectée. Il reçoit des signaux de commande com1, com2 du transistor T1 en mode opérationnel du circuit électronique qui sont générés par un circuit logique de type séquenceur 2. Dans l'exemple, lorsque le signal de commande com1 est activé, la tension Vm est appliquée sur la grille du transistor ce qui a pour effet de rendre le transistor T1 passant ; lorsque le signal de commande com2 est activé, la tension $V_{GN}$ est appliquée sur la grille du transistor ce qui a pour effet de bloquer le transistor T1.

Selon l'invention, on prévoit un autre signal de commande comv fourni par un circuit logique 3 de type séquenceur, sur activation du mode de test de vieillissement (mode V) du circuit électronique par un signal d'activation $f_{val}$. Dans ce mode de test, les modes de commande opérationnel com1 et com2 sont forcés à l'état inactif au moins jusqu'à l'obtention de la mesure de vieillissement, par exemple au moyen d'un signal de mode de test Mode V généré par le circuit 3.

Le signal de commande supplémentaire comv permet d'appliquer une tension de test prédéfinie $V_P$ sur le noeud A connecté à la grille du transistor, typiquement pendant une durée tc. Le noeud A de grille est ensuite isolé du circuit de commande 1, et se retrouve ainsi en haute impédance, avec un potentiel de départ $V_A=V_P$.

Un circuit de mesure de vieillissement 100 a une entrée connectée au noeud A. Il fournit la mesure du temps de charge ou décharge du noeud A, du niveau de précharge $V_P$ à un niveau de référence $V_{REF}$. Ce temps de charge ou décharge du noeud A est directement fonction du courant de fuite dans le diélectrique de grille.

Si on mesure un temps de charge, on aura $V_{REF} > V_P$ ; si on mesure un temps de décharge on aura $V_{REF} < V_P$.

En pratique, il y a charge ou décharge selon le sens du courant de fuite à travers le diélectrique : cela dépend du type du transistor et de ses conditions de polarisation. Dans l'exemple, le transistor T1 est de type PMOS et la tension de polarisation $V_P$ appliquée correspond à un état bloqué du transistor ($V_P \geq Vdd$) : le courant de fuite aura tendance à décharger la grille et on mesurera un temps de décharge. Si le transistor T1 avait été de type NMOS (sur la figure 3, il faudrait alors inverser la position de la source s et du drain, avec la prise b de substrat ou de caisson toujours attachée à la source), avec la tension de polarisation $V_P$ appliquée correspondant à un état bloqué du transistor ($V_P \leq Vm$) : le courant de fuite aurait tendance à charger la grille et on mesurerait un temps de charge.

La mesure ts obtenue en sortie du circuit de mesure 100 peut être comparée à un temps de charge ou de décharge de référence $t_{REF}$.

Un comparateur 200 à une valeur de référence $t_{REF}$ fournit une information de vieillissement correspondante :

- Si $tS \geq tREF$, les fuites sont faibles ce qui signifie que le diélectrique est en bon état. Il faut seulement continuer à surveiller.
- Si ts < tREF, les fuites sont devenues plus importantes, ce qui signifie que le diélectrique a vieilli.

En pratique la mesure de référence $t_{REF}$ ou $N_{REF}$ peut être fournie par un transistor de référence prévu sur le circuit, et qui n'est alimenté que dans le mode MS de suivi du vieillissement. Cependant, un procédé technologique de fabrication est caractérisé par des dispersions technologiques. Aussi, l'épaisseur du diélectrique du transistor de référence peut être éloignée de la valeur nominale. Notamment si elle est plutôt plus fine que l'épaisseur nominale caractéristique de la technologie considérée, le courant de fuite du transistor de référence sera trop élevé et une détermination d'une nouvelle consigne sur la base d'une comparaison par rapport à un tel transistor de référence aurait des effets contraires à ceux recherchés.

On pourrait utiliser comme mesure de référence, une mesure effectuée à l'origine sur la grille du transistor dont on veut suivre le vieillissement. Mais on est là encore tributaire des dispersions technologiques.

On préfèrera avantageusement une mesure de référence $t_{REF}$ correspondant à un diélectrique non vieilli aux valeurs nominales de la technologie et notamment une épaisseur nominale. Cette mesure sera typiquement déterminée à la fabrication du circuit, et stockée dans un élément de mémoire non volatile, typiquement un élément de mémoire ROM 201 (figure 3) du circuit électronique.

L'information de vieillissement fournie par le comparateur 200 est avantageusement exploitée pour diminuer le stress sur le diélectrique, en modifiant les conditions de polarisation du transistor.

C'est la fonction du circuit 300 d'évaluation des consignes de polarisation illustré sur la figure 3. En fonction de la valeur mesurée ts, ce circuit fournit au moins une nouvelle consigne de polarisation opérationnelle du transistor, en sorte de réduire le stress appliqué. Dans l'exemple illustré, le circuit 300 fournit ainsi une consigne de tension de polarisation opérationnelle à l'état bloqué $V_{GN}$, notée cons(VGN), par laquelle la tension $V_{GN}$ va être modifiée en conséquence.

Ceci peut se faire par exemple par le biais de l'étage 4 de génération des tensions nécessaires généralement prévu dans un circuit électronique. Par exemple, si le niveau de la tension $V_{GN}$ appliqué en opérationnel est un niveau logique, c'est à dire égal à Vdd dans l'exemple, on prévoit par exemple que l'étage 4 de génération de tension comprend un convertisseur de tension, sur une entrée de commande numérique duquel la consigne cons(VGN) sera appliquée. On obtiendra en sortie une tension $V_{GN}$ correspondante dont le niveau sera un peu plus faible que la valeur nominale de la tension Vdd, suivant la consigne demandée, par exemple plus faible de 50 millivolts.

Dans le cas où le niveau de la tension $V_{GN}$ appliqué en opérationnel est un niveau de type "analogique", c'est à dire supérieur à Vdd, cette tension $V_{GN}$ peut être fournie soit par un signal d'alimentation externe, soit par une pompe de charge. On prévoit alors d'appliquer la consigne cons(VGN) sur une entrée de commande numérique soit d'un convertisseur associé au signal d'alimentation externe, soit de la pompe de charge, de manière à obtenir en sortie une tension $V_{GN}$ conforme à la consigne.

Pour que la consigne élaborée par le circuit 300 en fonction du vieillissement continue de s'appliquer après une mise hors tension du circuit électronique, il convient de la mémoriser dans un élément de mémoire non volatile programmable 301. Ceci peut être très contraignant, en particulier en termes de coût, car les étapes technologiques mises en oeuvre pour fabriquer des mémoires non volatiles programmables telles que des mémoires flash par exemple, ne sont pas facilement intégrables à un circuit électronique de logique rapide. Tout est alors affaire de compromis entre les avantages : meilleur suivi, durée de vie optimisée, et les inconvénients : coût (place supplémentaire, intégration technologique).

Pour s'affranchir de cette contrainte, on peut prévoir une activation du mode de test de vieillissement systématiquement à chaque remise sous-tension du circuit électronique, afin de déterminer les consignes applicables.

On notera qu'il n'est pas obligatoire de prévoir une comparaison 200 à une valeur de référence $t_{REF}$ pour activer le circuit 300. On peut en effet appliquer directement la mesure de vieillissement ts au circuit 300 d'évaluation des consignes qui fournira en sortie des consignes correspondant aux conditions initiales optimales du circuit intégré tant qu'aucun vieillissement ne sera détecté.

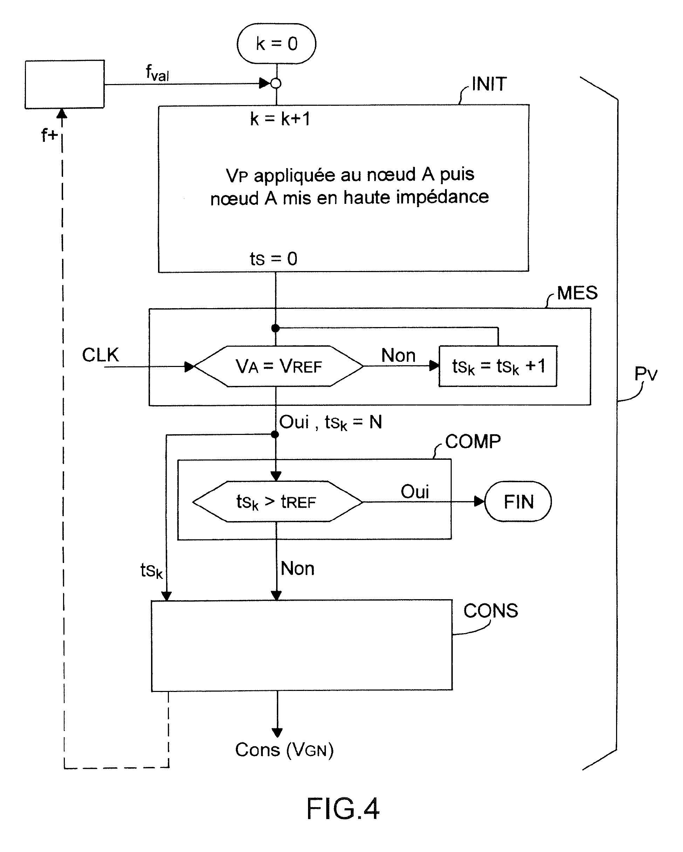

L'organigramme de la figure 4 illustre le procédé de test de vieillissement Pv qui vient d'être expliqué. Le procédé comprend ainsi essentiellement une phase d'initialisation INIT avec précharge à $V_P$ puis mise en haute impédance du noeud A de grille; une phase de mesure de vieillissement MES du temps de charge ou décharge ts du noeud A (circuit 300, figure 3); une phase de détermination DET, qui comprend une phase d'évaluation de consigne CONS (Circuit 300, figure 3) et éventuellement une phase de comparaison $C_{OMP}$ (Circuit 200, figure 3) préalable. Ce procédé de test peut être activé au moins une fois systématiquement à la mise sous tension, par activation d'un signal correspondant $f_{val}$.

Pour assurer un suivi plus poussé, on peut activer le test de vieillissement Pv de façon périodique, par exemple toutes les 100 heures, pour une durée de vie projetée du circuit électronique de 100000 heures.

Dans un perfectionnement, on prévoit d'adapter la fréquence d'activation du test au niveau de vieillissement constaté. Typiquement, si la vitesse de dégradation du diélectrique se dégrade, on augmente la fréquence d'activation du test (f+), afin de ralentir au mieux le processus de vieillissement. Ceci suppose de pouvoir conserver des valeurs successives $ts_k$ de la mesure du temps de charge ou décharge en mémoire non volatile, pour conserver ces valeurs même entre deux coupures d'alimentation. On a vu que cette option peut être coûteuse.

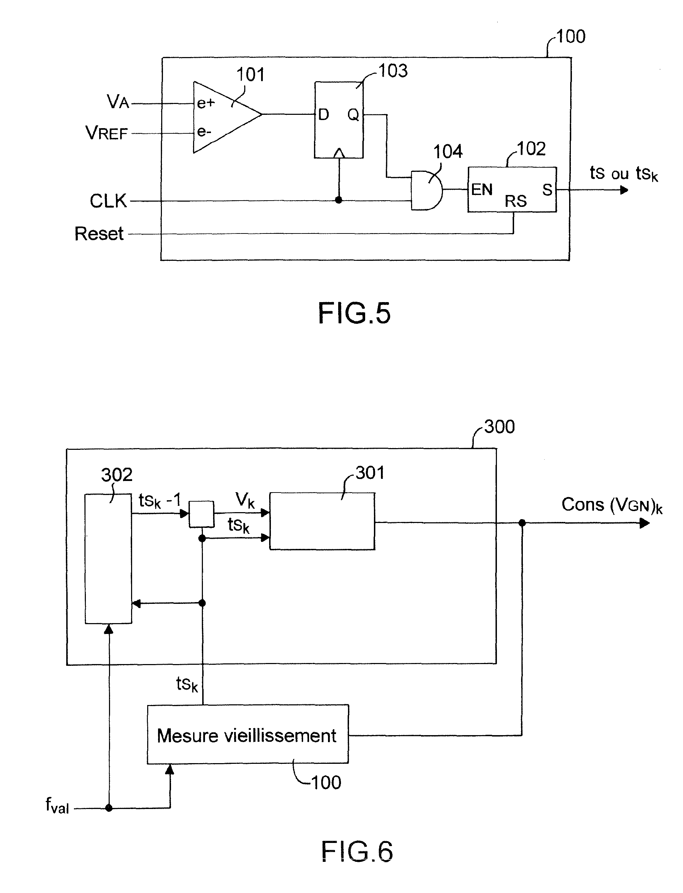

La figure 5 illustre un exemple de réalisation du circuit de mesure 100 du temps de charge ou de décharge ts. Il comprend un comparateur de tension 101, qui a une première entrée e+ connectée à la grille, et qui reçoit sur une deuxième entrée e-, la tension de référence $V_{REF}$ ; un compteur 102, qui est réinitialisé à chaque nouvelle activation du test ($f_{val}$) par un signal Reset, et qui va ensuite s'incrémenter d'une unité à chaque coup d'horloge CLK tant que la tension VA au noeud A n'est pas égale à $V_{REF}$. Des portes logiques sont prévues pour piloter le compteur de manière appropriée. Dans l'exemple, la sortie du comparateur est à 1 tant que l'égalité n'est pas vérifiée et passe à zéro quand l'égalité est vérifiée. Une bascule de type D 102 et une porte ET 103 sont alors utilisées pour combiner de manière appropriée la sortie du comparateur avec l'impulsion horloge, et fournir le signal d'incrémentation sur l'entrée correspondante EN du compteur. A la fin de l'évaluation, le compteur fournit en sortie un nombre N de coups d'horloge qui est la mesure ts du temps de charge ou décharge au moment du test. Ce nombre N peut être comparé (200, figure 3) à un nombre $N_{REF}$ correspondant à la mesure du temps de référence $t_{REF}$ du temps de charge ou décharge d'un diélectrique non vieilli correspondant.

Le circuit 300 d'élaboration de la consigne peut être une table de conversion qui fait correspondre à chaque valeur de N (ts), une valeur numérique qui forme la consigne correspondante. Dans ce cas la table de conversion est prédéfinie à l'avance et intégrée dans le circuit électronique. Elle peut comprendre en pratique une pluralité de consignes, chaque consigne correspondant à une valeur N, ou une plage de valeurs N1 $\leq$ N $\leq$ N2.

Le circuit d'élaboration de la consigne peut être plus élaboré et notamment, comme illustré sur la figure 6, mettre en oeuvre un asservissement numérique 301 permettant d'élaborer une consigne en fonction de la vitesse de dégradation du diélectrique $v_k$, typiquement calculée à partir de la valeur mesurée courante $tS_k$ ($N_k$) et des valeurs de mesure précédentes mémorisées $tS_{k-1}$ ($N_{k-1}$), .... A chaque activation du mode de suivi du vieillissement, la mesure $tS_k$ fournie par le circuit de mesure 100 doit alors être mémorisée dans une mémoire 302. De cette façon, le vieillissement peut être caractérisé dans le temps, et la boucle d'asservissement 301 tend à stopper cette évolution.

La mémoire 302 doit être programmable et non volatile, pour être conservée en absence d'alimentation électrique. On a déjà vu que cela peut être une contrainte, notamment en matière de coût. Mais en contrepartie, il est possible d'obtenir une adaptation fine du stress.

Dans une variante de l'invention, et comme illustré en pointillé sur la figure 3, on prévoit que la tension de test $V_P$ elle-même est modifiée au fur et à mesure du vieillissement, afin que le test de vieillissement n'induise pas un stress supplémentaire sur le diélectrique, alors qu'en opérationnel on a diminué ce stress. On peut ainsi être amené à prédéfinir une pluralité de valeurs de tension de test $V_P$, en fonction du vieillissement. Ceci peut aussi amener à modifier la valeur de la tension de référence $V_{REF}$. Dans ce cas, l'étape de détermination DET de la figure 4 comprend une phase de détermination de la tension de test $V_P$ à appliquer à une prochaine mesure en fonction de la mesure de vieillissement courante effectuée.

Dans un exemple de mise en oeuvre, on prévoit alors l'utilisation d'une pluralité de tables de conversion prédéfinies, une par valeur de tension de test possible. Chaque table fournit pour une valeur donnée de mesure de vieillissement, ou pour une plage de valeurs, un ensemble de consignes correspondantes comprenant en plus de consignes de tensions de polarisation opérationnelles (Cons(VGN)), une consigne de tension de test Cons(VP), voire une consigne de tension de référence Cons(VREF). Si on reprend l'exemple de la figure 3, toutes ces consignes vont être appliquées en entrée numérique de convertisseurs de tension correspondants ou de pompes de charge pour générer chacune une valeur de tension correspondante. S'agissant des consignes de tensions de polarisation opérationnelles, (Cons($V_{GN}$)) ces consignes s'appliquent immédiatement. La consigne de tension de test Cons($V_P$), et éventuellement la consigne de tension de référence Cons(VREF) s'appliqueront pour la prochaine mesure de vieillissement.

Un test de vieillissement selon l'invention peut être appliqué avantageusement à un transistor de puissance d'un étage analogique d'un circuit électronique intégré, par exemple à un transistor de puissance qui serait interposé en série entre la borne d'alimentation Vdd du circuit électronique intégré et une partie active du circuit (CA), pour permettre d'alimenter la partie active CA dans un mode actif, ou le désalimenter dans un mode de veille.

Si on reprend la figure 3, on aurait alors le fonctionnement suivant : - en mode actif, correspondant au signal de commande com1: le transistor est rendu fortement conducteur et laisse passer tout le courant nécessaire au circuit actif, avec une chute de tension minimale donc sans consommation de puissance inutile ;

- en mode de veille, correspondant au signal de commande com2: il est bloqué pour interrompre le courant de la source d'alimentation vers le reste du circuit intégré, par sur-polarisation inverse de grille. Dans ce cas la tension $V_{GN}$ est égale à une tension Vcc supérieure à la tension logique Vdd, fournie par une pompe de charge intégrée ou par une alimentation externe du circuit électronique. Dans un exemple, la tension Vdd peut être de 1,2 volts, norme pour des petits appareils portables, et la tension Vcc peut-être de 2,5 volts.

Dans un tel exemple le niveau de la tension de test $V_P$ utilisé correspondra typiquement à un niveau proche ou égal au niveau $V_{GN}$ de grille appliqué au transistor en mode de veille, à l'origine du stress. Cette tension peut être produite en pratique par une pompe de charges intégrée du circuit électronique ou fournie en externe.

En pratique, on notera que la tension de test $V_P$ appliquée ne sera généralement pas directement la tension $V_{GN}$. En effet, dans le cas d'un transistor de puissance, la tension $V_{GN}$ appliquée en opérationnel peut varier pour obtenir les courants de fuite les plus faibles possible en fonction de conditions environnementales changeantes, par exemple la température. Or, si l'on veut caractériser le vieillissement, il faut nécessairement précharger la grille du transistor considéré à une valeur $V_P$ fixe dans le temps, de manière à ce que les différentes mesures soient cohérentes.

Dans un tel exemple d'application pratique, l'invention va permettre de diminuer progressivement le niveau opérationnel de tension $V_{GN}$ à l'origine du stress au fur et à mesure du vieillissement mesuré. Selon les applications, il pourrait être envisagé d'une manière plus générale de modifier les conditions de polarisation en tension du transistor, c'est à dire y compris les tensions appliquées sur le drain et la source, ou la tension appliquée en mode passant.

De préférence, la tension de test $V_P$ et les conditions de tensions de polarisation modifiées ($V_{GN}$ en particulier) correspondent à un transistor à l'état bloqué.

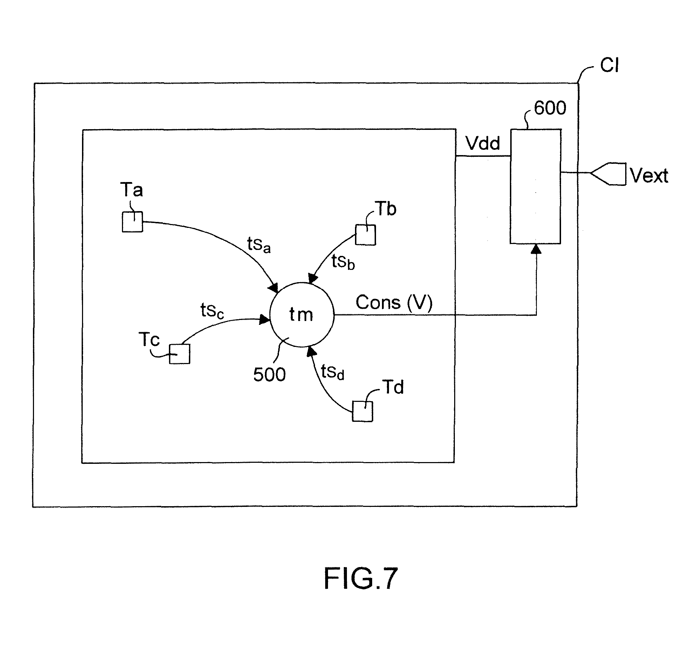

La figure 7 illustre un autre exemple d'application de l'invention, pour diminuer le stress de transistors à effet de champ utilisés dans des portes ou circuits logiques. Si on reprend la figure 3, cela correspond au cas où le niveau $V_{GN}$ correspond au niveau logique Vdd.

Il s'agit alors de caractériser le vieillissement de l'ensemble du circuit intégré CI et d'adapter en conséquence le niveau de tension de l'alimentation logique Vdd directement. Pour pouvoir caractériser le vieillissement de l'ensemble du circuit, on prévoit avantageusement des transistors témoins Ta, Tb, Tc, Tb dispersés géographiquement sur le circuit, de manière à s'affranchir des dispersions technologiques. On prévoit alors des moyens 500 pour obtenir une mesure du temps de charge ou décharge de chacun des transistors, et de caractériser une dégradation moyenne à partir de ces mesures tsa, tsb, tsc, tsd, pour élaborer une consigne Cons(V) correspondante. Cette consigne est appliquée par exemple en entrée d'un convertisseur numérique 600 qui va permettre soit de maintenir le niveau de tension de la tension d'alimentation Vdd du circuit électronique, tant qu'aucun vieillissement n'est constaté, ou d'adapter le niveau de la tension d'alimentation Vdd du circuit électronique au vieillissement constaté. La tension de test appliquée correspond de préférence à un transistor à l'état bloqué. On peut prévoir que le même circuit de mesure 500 effectue les différentes mesures tsa, tsb, tsc, tsd,, et leur moyenne tm, pour fournir la consigne Cons (V).

En pratique, dans cet exemple d'application de l'invention au suivi d'un circuit alimenté à tension nominale, la tension de test $V_P$ peut tout simplement être la tension d'alimentation Vdd.

Toutes les variantes décrites en relation avec les figures 3 à 6, notamment pour l'obtention de la valeur de référence, l'élaboration de la consigne, l'adaptation des tensions de test et de référence au vieillissement du circuit intégré s'appliquent ici de la même manière.

L'invention permet de maintenir un circuit électronique dans des conditions de performances de fonctionnement optimales, tant qu'aucun vieillissement n'est constaté. En cas de vieillissement, les performances sont un peu dégradées pour augmenter la durée de vie de plus d'un ordre de grandeur.

**Revendications**

1. Procédé de test (Pv) pour augmenter la durée de vie d'un transistor à effet de champ (T1) dans un circuit électronique, **caractérisé en ce qu'**il comprend :

    - une phase de précharge (INIT) de la grille (A) dudit transistor à une tension de test prédéfinie $V_P$, puis la mise en haute impédance de la grille du transistor,
    - une phase de mesure de vieillissement (MES) à l'aide d'un temps de charge ou de décharge (ts) de la grille dudit transistor pour passer dudit niveau de tension de test prédéfinie ($V_P$) à une tension de référence ($V_{REF}$),
    - une étape de détermination (DET), pour décider le maintien ou la modification d'au moins une tension de polarisation opérationnelle dudit transistor, en fonction de ladite mesure de vieillissement.

2. Procédé selon la revendication 1, **caractérisé en ce que** ladite étape de détermination comprend l'application de ladite mesure de vieillissement (ts) en entrée d'une table de conversion (300) qui fournit en sortie au moins une consigne de tension de polarisation opérationnelle cons(VGN) correspondante.

3. Procédé selon la revendication 1, **caractérisé en ce que** chaque mesure de vieillissement ($tS_k$) est stockée en mémoire non volatile (302) et **en ce que** l'étape de détermination (DET) comprend un asservissement (301) à une vitesse ($v_k$) de dégradation du vieillissement calculée à partir de mesures de vieillissement mémorisées et de la mesure courante, pour fournir au moins une consigne de tension de polarisation opérationnelle (cons(VGN)$_k$).

4. Procédé selon la revendication 3, **caractérisé en ce que** ladite mesure de vieillissement est réalisée par un compteur (102) initialisé à chaque nouvelle phase de mesure, et incrémenté ou décrémenté à chaque coup d'une horloge (CLK), tant que la tension de grille (VA) n'est pas égale à ladite tension de référence ($V_{REF}$).

5. Procédé selon l'une quelconque des revendications 1 à 4, dans lequel l'étape de détermination (DET) comprend la détermination de la tension de test ($V_P$) à appliquer à une prochaine mesure en fonction de ladite mesure de vieillissement.

6. Procédé selon la revendication 5, **caractérisé en ce que** la détermination de la tension de polarisation opérationnelle du transistor est fonction de la mesure de vieillissement courante et de la tension de test ($V_P$) appliquée dans la phase de mesure correspondante.

7. Procédé selon la revendication 6 en combinaison avec la revendication 2, **caractérisé en ce qu'**il comprend l'utilisation de plusieurs tables de conversion, une par valeur de tension de test ($V_P$) possible, et **en ce qu'**à chaque nouvelle phase de mesure, la table de conversion correspondant à la valeur de la tension de test appliquée dans ladite phase de mesure est sélectionnée.

8. Procédé selon la revendication 6 à 7, **caractérisé en ce qu'**à chaque valeur de tension de test $V_P$, correspond une tension de référence ($V_{REF}$) déterminée.

9. Procédé selon l'une quelconque des revendications précédentes, **caractérisé en ce que** lesdites tensions de test et de polarisation opérationnelle correspondent à un transistor dans un état bloqué.

10. Procédé selon l'une quelconque des revendications précédentes, **caractérisé en ce qu'**il est activé périodiquement, à une fréquence d'activation ($f_{val}$).

11. Procédé selon la revendication 10, **caractérisé en ce que** ladite fréquence d'activation ($f_{val}$) augmente avec le vieillissement.

12. Procédé selon l'une quelconque des revendications précédentes, **caractérisé en ce qu'**il comprend une étape de comparaison (COMP) de la mesure de vieillissement (ts) à une valeur de référence ($t_{REF}$), pour fournir une information de vieillissement correspondante.

13. Procédé selon la revendication 12, **caractérisé en ce que** ladite valeur de référence correspond à un diélectrique de transistor non vieilli, et d'épaisseur nominale.

14. Circuit électronique comprenant au moins un transistor à effet de champ, **caractérisé en ce qu'**il comprend un circuit de mesure de vieillissement (CMV) dudit transistor activé ($f_{val}$) au moins à chaque mise sous tension du circuit électronique, ledit circuit de mesure comprenant

    - des moyens ($V_P$, comv) pour précharger la grille (A) dudit transistor à une tension de test prédéfinie $V_P$, puis la mettre en haute impédance, des moyens (100) pour fournir une mesure de vieillissement (ts) correspondant à un temps de charge ou décharge de la grille à une tension de référence ($V_{REF}$) et des moyens (300) de détermination d'au moins une tension de polarisation opérationnelle du transistor ($V_{GN}$), en fonction de ladite mesure de vieillissement.

15. Circuit électronique selon la revendication 14, **ca-**

**ractérisé en ce qu'**il comprend une pluralité de transistors à effet de champ (Ta, Tb, Tc, Td) dispersés sur le circuit, polarisés sous des conditions normales de tension correspondant à la tension d'alimentation logique dudit circuit, et au moins un circuit de mesure de vieillissement (500) pour effectuer une mesure de vieillissement de chacun desdits transistors, et modifier le cas échéant la tension d'alimentation logique (Vdd) du circuit en fonction de la moyenne (tm) desdites mesures (tsa, tsb, tsc, tsd).

16. Circuit électronique selon la revendication 14, comprenant au moins un transistor de puissance à effet de champ, dans lequel un circuit de mesure de vieillissement (CMV) est associé au dit transistor de puissance, pour adapter des conditions de polarisation en tension (cons($V_{GN}$)) dudit transistor de puissance en fonction de ladite mesure.

17. Circuit électronique selon l'une quelconque des revendications 14 à 16, **caractérisé en ce que** ladite tension de test $V_P$ et lesdites conditions de polarisation correspondent à un transistor à l'état bloqué.

Vdd

Vdd —g| d

s

Vm

## FIG.1a

Vdd

Vm —g| d

s

Vm

## FIG.1b

Tension de grille
appliquée (V)

6,0

SBD

5.9

BD

5.8

0   10   20   30   40

Durée du Stress appliqué (s)

## FIG.2

FIG.3

FIG.4

**FIG.5**

**FIG.6**

FIG.7

**Office européen**
**des brevets**

**RAPPORT DE RECHERCHE EUROPEENNE**

Numéro de la demande

EP 08 10 1163

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2006/158210 A1 (TSAI CHING-WEI [TW] ET AL) 20 juillet 2006 (2006-07-20) <br> * abrégé; figures 1-4,6 * <br> * alinéas [0007], [0009], [0010] * <br> ----- | 1-17 | INV. <br> G01R31/26 |
| A | ERHONG LI ET AL: "Projecting Lifetime of Deep Submicron MOSFETs" <br> IEEE TRANSACTIONS ON ELECTRON DEVICES, IEEE SERVICE CENTER, PISACATAWAY, NJ, US, vol. 48, no. 4, avril 2001 (2001-04), XP011017570 <br> ISSN: 0018-9383 <br> * abrégé * <br> * page 675, colonne 1, ligne 40 - colonne 2, ligne 46; figure 12 * <br> * page 676, colonne 1, ligne 5 - ligne 46; figure 7 * <br> ----- | 1-17 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Berlin | 26 mai 2008 | Binger, Bernard |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 10 1163

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-05-2008

| Document brevet cité au rapport de recherche | Date de publication | Membre(s) de la famille de brevet(s) | Date de publication |
|---|---|---|---|
| US 2006158210    A1 | 20-07-2006 | JP    2006194875  A<br>KR  20060092995  A<br>TW       267950  B | 27-07-2006<br>23-08-2006<br>01-12-2006 |

Pour tout renseignement concernant cette annexe : voir Journal Officiel de l'Office européen des brevets, No.12/82

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **JAMES STATHIS.** Gate Oxide Reliability for nanoscale CMOS. *International Symposium on Physical and Failure Analysis,* Juin 2005, 127-130
- **H. KAWAGUCHI et al.** A super Cut-Off CMOS (SCCMOS), Scheme for 0,5 V Supply Voltage with Picoampere Stand-by Current. *IEEE Journal of Solid State Circuits,* Octobre 2000, vol. 35 (10), 1498-1501
- **DEPAS et al.** Soft Breakdown of Ultra-thin Gate Oxide Layers. *IEEE Transactions on Electron devices,* Septembre 1996, vol. 43 (3

- **M. A. KHALIL et al.** Extreme-Voltage Stress Vector Generation of Analog CMOS ICs for Gate-Oxide Reliability Enhancement. *Int. Test Conference,* 2001, 348-357
- **Z. HAN et al.** Gate leakage current simulation by Boltzman Transport Equation and its dependence on the gate oxide thickness. *International conference on Semiconductor Processes and devices SISPAD,* Septembre 1999, 247-250